Europäisches Patentamt

European Patent Office

Office européen des brevets

(11) Veröffentlichungsnummer: **0 135 918**
**A1**

(12) **EUROPÄISCHE PATENTANMELDUNG**

(21) Anmeldenummer: **84111218.8**

(22) Anmeldetag: **20.09.84**

(51) Int. Cl.⁴: **G 01 D 11/08, G 01 D 13/22, G 01 R 1/08, G 12 B 11/04**

(30) Priorität: **23.09.83 DE 3334377**

(43) Veröffentlichungstag der Anmeldung: **03.04.85**
**Patentblatt 85/14**

(84) Benannte Vertragsstaaten: **DE FR GB IT SE**

(71) Anmelder: **ITT INDUSTRIES INC., 320 Park Avenue, New York, NY 10022 (US)**

(84) Benannte Vertragsstaaten: **FR GB IT SE**

(71) Anmelder: **Müller & Weigert GmbH, Kleinreuther Weg 88, D-8500 Nürnberg 10 (DE)**

(84) Benannte Vertragsstaaten: **DE**

(72) Erfinder: **Mirbeth, Heinz Georg, Fasanenweg 49, D-8501 Eckental (DE)**
Erfinder: **Nentwich, Eugen Hans, Siebenbürgener Strasse 6, D-8501 Schwarzenbruck (DE)**
Erfinder: **Niklas, Günter Wilhelm, Nietzschestrasse 10, D-8500 Nürnberg (DE)**

(74) Vertreter: **Fritsch, Helmut, Dipl.-Chem. et al, c/o Standard Elektrik Lorenz AG Patent- und Lizenzwesen Postfach 300 929 Kurze Strasse 8, D-7000 Stuttgart 30 (DE)**

(54) **Messinstrument.**

㉗ Messinstrument mit einem um eine Messwerkachse drehbaren Messwerkteil und einem radial auf der Achse befestigten Zeiger (1). Zum Ausbalancieren der Massen wird ein Massekörper (9) vorgesehen, der längs des Zeigers (1) verschiebbar ist. Der Massekörper (9) kann sowohl auf dem Zeiger (1) angeordnet sein als auch innerhalb des Zeigers (1). Bei einer besonders zweckmässigen Ausführungsform ist auf der Rückseite des Zeigers eine Führungsnut (8) vorgesehen, in der eine Metallkugel (9) verschiebbar angeordnet ist. Das Balancieren lässt sich so sehr leicht durchführen und besondere Balancierarme sind nicht erforderlich.

ACTORUM AG

0135918

H.G.Mirbeth-E.H.Nentwich-G.W.Niklas 34-2-1

Meßinstrument

Die Erfindung bezieht sich auf ein Meßinstrument mit einem um eine Meßwerkachse drehbaren Meßwerkteil und einem radial auf der Achse befestigten Zeiger, bei dem zum Ausbalancieren der beweglichen Masse mit der Meßwerkachse verbundene, radial hierzu verschiebbare Massekörper vorgesehen sind.

Bei Meßinstrumenten mit einem drehbaren Meßwerkteil und einem auf der Achse des Meßwerkteils befestigten Zeiger muß ein Ausbalancieren der Massen vorgenommen werden, damit die Zeigerstellung in jeder Lage des Meßinstrumentes gleich ist und bei seitlichen Beschleunigungen die Zeigerstellung nicht beeinflußt wird. Zum Ausbalancieren sind meist mit der Meßwerkachse verbundene radial abstehende Arme vorgesehen, auf denen entweder zusätzliche Massen angebracht werden oder auf denen Massen verschiebbar angeordnet sind. Das Anbringen von Massen geschieht beispielsweise durch Aufbringen von Lot mittels eines Lötkolbens. Hierzu ist viel Geschick erforderlich, um gerade so viel Lot aufzubringen wie zum Ausbalancieren erforderlich ist. Es sind hierzu in der Regel mehrere Versuche nötig, um die richtige Masse aufzubringen. Dieses Verfahren ist somit umständlich und zeitraubend und daher teuer.

Man hat aber auch schon das Ausbalancieren derart vorgenom-

- 5 -

H.B.Mirbeth-E.H.Nentwich-G.W.Niklas 34-2-1

men, daß auf den mit der Meßwerkachse verbundenen Armen kleine Massen verschoben werden. Als solche Massen hat man z. B.
Drahtwendel aufgebracht, die nach dem Verschieben in die
richtige Lage zusätzlich befestigt werden müssen, beispielsweise durch ein Klebemittel. Man hat auch die Balancierarme
mit einem Gewinde versehen, so daß hierauf mit einem Gewinde versehene Massekörper, wie z. B. Muttern, durch Verdrehen
verschoben werden können. Auch hier ist es in der Regel erforderlich, daß die Muttern in ihrer Lage geeignet fixiert
werden. Durch das Fixieren der Massekörper wird aber zusätzliche Masse aufgebracht, die in der Regel in ihrer Menge
nicht definiert ist, so daß das richtige Ausbalancieren großenteils Gefühlssache ist.

Für das Balancieren sind also bei den bekannten Meßinstrumenten zusätzliche Balancierarme erforderlich. Da sich diese
Balancierarme in der Regel in entgegengesetzter Richtung zur
Zeigerachse erstrecken, sind diese verhältnismäßig kurz, so
daß dafür entsprechend größere Massen darauf angebracht oder
verschoben werden müssen. Hierdurch ergibt sich aber schon
bei einem geringen Verschiebungsweg eine größere Änderung
in der Masseverteilung, so daß eine genaue Masseausbalancierung schwierig ist.

Der Erfindung liegt die Aufgabe zugrunde, ein Meßinstrument
zu schaffen, bei dem sich die Massen einfach und genau ausbalancieren lassen, ohne daß zusätzliche Balancierarme erforderlich sind.

Diese Aufgabe wird durch die im Kennzeichen des Anspruchs 1
genannten Merkmale gelöst.

Vorteilhafte Weiterbildungen der Erfindung können den Unter-

0135918

H.G.Mirbeth-E.H.Nentwich-G.W.Niklas 34-2-1 ansprüchen entnommen werden.

Gemäß der Erfindung wird der Zeiger als Träger für verschiebbare Massekörper zum Ausbalancieren verwendet. Zusätzliche Balancierarme sind daher überflüssig. Bei der Herstellung des Meßinstrumentes werden die Toleranzen für die Masseverteilung der beweglichen Teile des Meßinstrumentes so gelegt, daß in Zeigerrichtung zu wenig Masse vorhanden ist. Durch längs des Zeigers verschiebbare Massekörper wird dann ein Ausbalancieren des drehbaren Meßwerkteils vorgenommen. Wenn der Zeiger auf beiden Seiten über die Meßwerkachse übersteht, so können diese verschiebbaren Massekörper natürlich sowohl auf dem langen Zeigerteil als auch auf dem kurzen überstehenden Teil angebracht sein. Besonders vorteilhaft ist es jedoch, die Massekörper auf dem langen Zeigerteil anzuordnen, weil hier ein sehr langer Verschiebungsweg zur Verfügung steht, so daß die Masse des verschiebbaren Massekörpers verhältnismäßig klein sein kann. Die zum Ausbalancieren vorgesehenen Massekörper können dabei entweder außen am Zeiger angebracht sein oder im Inneren des Zeigers oder auch in einer Nut, die im Zeiger vorgesehen ist. Die längs des Zeigers verschiebbaren Massekörper sind so ausgebildet, daß sie ohne Aufbringen zusätzlicher Masse in ihrer Stellung fixiert werden können. Dies kann beispielsweise dadurch erreicht werden, daß Massekörper verwendet werden, die nach dem Ausbalancieren durch Erwärmung ihr Volumen ändern und sich so unverschiebbar mit dem Zeiger verbinden oder daß Massekörper und/oder Zeiger so ausgebildet sind, daß eine kraftschlüssige Verbindung durch Festklemmen erzielt wird.

Vorteilhafte Ausbildungen der Erfindung sollen anhand der Figuren näher erläutert werden.

H.G.Mirbeth-E.H.Nentwich-G.W.Niklas 34-2-1

In den Fig. 1 bis 3 sind Meßinstrumentenzeiger dargestellt, auf denen verschiedene Massekörper verschiebbar angeordnet sind.

Fig. 4 zeigt einen hohlen Zeiger im Längsschnitt und

Fig. 5 einen Querschnitt gemäß der Schnittlinie A-A von Fig. 4, innerhalb dessen ein Massekörper verschiebbar angeordnet ist.

Fig. 6 zeigt die Seitenansicht und

Fig. 7 die zugehörige Ansicht von unten eines Zeigers, der eine Nut zur Aufnahme eines Massekörpers besitzt.

Fig. 8 zeigt einen Schnitt längs der Schnittlinie A-A von Fig. 6.

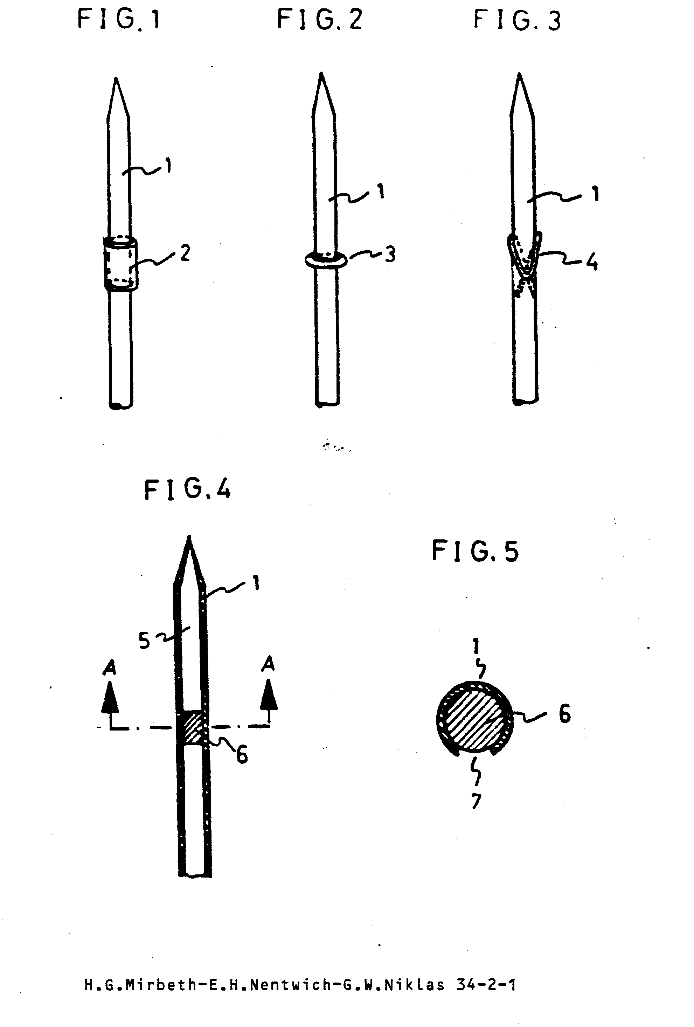

Auf dem in Fig. 1 dargestellten Meßwerkzeiger 1 ist ein etwa zylindrischer Massekörper 2 verschiebbar angeordnet, der aus einem Material besteht, das bei Erwärmung schrumpft. Es handelt sich also vornehmlich um ein Stück Schrumpfschlauch. Hierbei handelt es sich um ein handelsübliches und billiges Material. Zum Ausbalancieren wird der Schrumpfschlauch 2 auf dem Zeiger 1 verschoben, bis die Balance hergestellt ist, wonach der Schrumpfschlauch 2 vorzugsweise mittles einer fokussierten Wärmestrahlung, zum Schrumpfen gebracht wird, so daß er auf dem Zeiger 1 unverschiebbar fixiert ist. Da beim Schrumpfen des Schrumpfschlauches 2 keine Masseveränderung eintritt, bleibt die Balance voll erhalten.

Fig. 2 zeigt eine weitere mögliche Ausführungsform der Erfindung. Auf dem Zeiger 1 ist ein Massekörper 3 in Form eines Ringes angeordnet. Vorzugsweise handelt es sich um einen

0135918

H.G.Mirbeth-E.H.Nentwich-G.W.Niklas 34-2-1

Ring aus elastischem Material, beispielsweise einem sogenannten O-Ring. Solche Ringe sind in allen möglichen Grössen handelsüblich und können in ihrem Durchmesser so gewählt werden, daß sie auf dem Zeiger 1 leicht verschiebbar
sind, aber infolge ihrer Elastizität die gegebene Lage beibehalten. Das Balancieren geschieht hier ebenfalls durch
Verschieben des O-Ringes 3 auf dem Zeiger 1. Eine zusätzliche Fixierung des Ringes nach dem Balancieren ist nicht erforderlich.

Eine weitere Ausführungsform der Erfindung ist in Fig. 3
dargestellt. Auf dem Zeiger 1 ist eine Drahtklammer 4 verschiebbar angeordnet. Diese Klammer besteht vorzugsweise
aus einem elastischen Material, so daß sie sich auf dem Zeiger festklemmt, aber trotzdem leicht verschoben werden kann.
Auch hier ist nach dem Verschieben keine Fixierung erforderlich.

Die Ausführungsformen der Erfindung nach den Fig. 1 bis 3
empfehlen sich besonders bei solchen Meßinstrumenten, bei
denen der Zeiger auf einem großen Teil seiner Länge verdeckt ist. Dies ist beispielsweise bei Instrumenten der Fall,
bei denen sich die Skala auf der Schmalseite des Instrumentes
befindet und der Zeiger an seinem Ende rechtwinkelig umgebogen ist. Bei solchen Meßinstrumenten ist dann der größte Teil
der Zeigerlänge nicht sichtbar, so daß auch die zum Balancieren aufgebrachten Massen nicht stören.

In den Fig. 4 und 5 ist ein Zeiger im Längsschnitt bzw. im
Schnitt gemäß der Schnittlinie A-A von Fig. 4 dargestellt,
der innen hohl ist. Es handelt sich um einen sogenannten
Rohrzeiger. Hier kann eine verschiebbare Masse 6 innerhalb

des Hohlraumes 5 angeordnet sein. Der Massekörper 6 kann z. B. ein Metallzylinder sein. Der Zeiger 1 weist einen Längsschlitz 7 wie in Fig. 5 sichtbar auf, in den ein schmales Werkzeug zum Verschieben des Massekörpers 6 eingeführt werden kann. Vorzugsweise besteht der Rohrzeiger 1 aus einem Material, das einen schwachen Klemmdruck auf den Massekörper 6 ausübt, so daß dieser sich nicht selbst verschieben kann. Durch Einführen eines Werkzeugs in den Schlitz 7 wird der Massekörper 6 im Hohlraum 5 des Zeigers 1 so verschoben, daß die Balance hergestellt wird. Wenn der Schlitz 7 an der Seite des Zeigers oder auf der Rückseite des Zeigers angeordnet ist, so sind bei normaler Betrachtung des Meßinstrumentes weder der Schlitz noch der Massekörper sichtbar. Eine solche Ausführungsform empfiehlt sich daher, wenn der Zeiger 1 auf seiner ganzen Länge im Meßinstrument sichtbar ist.

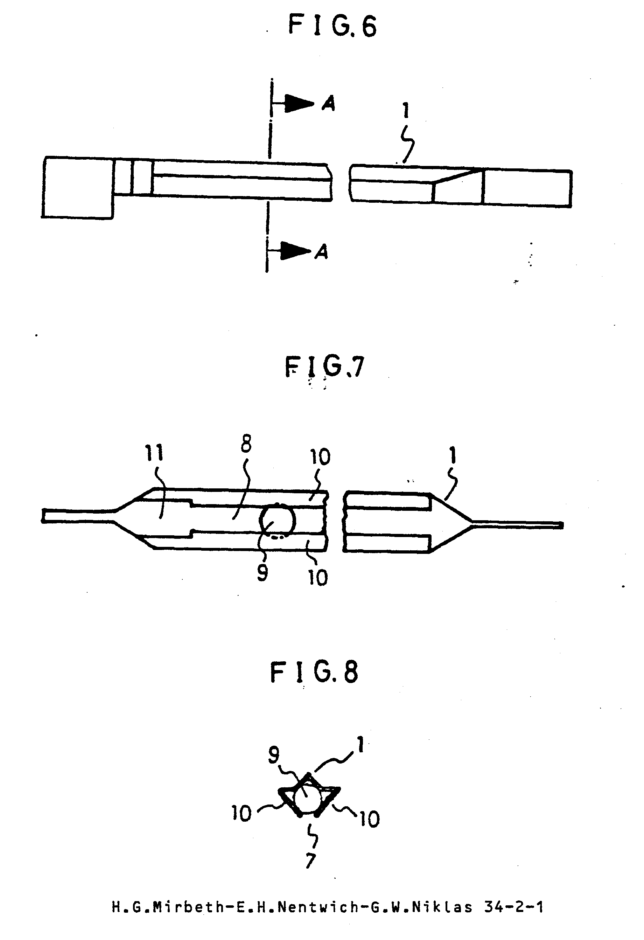

In den Fig. 6 bis 8 sind verschiedene Ansichten eines Zeigers dargestellt, der eine Führungsnut besitzt, in der ein Massekörper zum Ausbalancieren verschiebbar angeordnet ist. Fig. 6 zeigt eine Seitenansicht des Zeigers, Fig. 7 eine Ansicht von der Rückseite und Fig. 8 einen Schnitt durch den Zeiger nach der Schnittlinie A-A von Fig. 6.

Bei dieser besonders vorteilhaften Ausführungsform ist der Zeiger aus einem dünnen Blech so gefaltet, daß er eine Führungsnut für einen Massekörper bildet. Die Führungsnut wurde auf der Rückseite des Zeigers 1 dadurch gebildet, daß die Kanten 10 des Bleches umgefaltet wurden. Damit der Zeiger eine genügende Steifigkeit hat, hat er einen etwa sternförmigen Querschnitt, wie dies aus Fig. 8 ersichtlich ist. Aus dieser Fig. ist weiter ersichtlich, daß der Führungskanal 8 so ausgebildet ist, daß der Massekörper zwischen Längskanten gehalten ist. Dadurch ergibt sich einerseits eine gu-

0135918

H.G.Mirbeth-E.H.Nentwich-G.W.Niklas 34-2-1

te Zentrierung des Massekörpers in der Führungsnut und andererseits ein geringer Widerstand beim Verschieben des Massekörpers. Die Blechkanten 10 sind so weit herumgebogen, daß sie etwas federnd an dem Massekörper 9 anliegen. Zum Einsetzen des Massekörpers in die Führungsnut ist weiter ein Ausschnitt 11 vorgesehen, wie dies aus Fig. 7 ersichtlich ist.

Besonders vorteilhaft ist es, als Massekörper eine Metallkugel 9 zu verwenden. Solche Kugeln sind handelsüblich und aus verschiedenem Material erhältlich. Er kann aber auch als Metallzylinder ausgebildet sein. Die Kugel 9 wird in den Ausschnitt 11 eingesetzt, und dann in die Führungsnut 8 eingeschoben.Durch ein einfaches Werkzeug kann die Kugel 9 in der Führungsnut 8 des Zeigers 1 verschoben werden, bis die Balance erreicht ist. Durch die Federwirkung des Bleches, aus dem der Zeiger besteht, wird die Kugel in der gewünschten Lage sicher festgehalten.

Wenn die Gefahr besteht, daß das Meßwerk durch ein magnetisches Material beeinflußt wird, wird eine Kugel aus nicht magnetischem Material, wie z. B. Bronce, verwendet. Wenn dies jedoch keine Rolle spielt, kann eine Kugel verwendet werden, die mindestens teilweise aus magnetiserbarem Material besteht. Dies hat den weiteren Vorteil, daß die Kugel mittels eines Magnetfeldes verschoben werden kann, d. h. daß die Balancierung automatisch durchgeführt werden kann.

Bei der Verwirklichung der Erfindung wurde ein Zeiger nach den Fig. 6 bis 8 verwendet, der aus einem 0,05 dicken Blech aus einer Aluminiumlegierung besteht. Der Zeiger hatte eine Gesamtlänge von 54 mm, das verbreiterte Mittelstück mit der Führungsnut hatte eine Länge von 42 mm. Als Massekörper wurde eine Broncekugel mit einem Durchmesser von 1 mm verwen-H.G. Mirbeth-E.H.Nentwich-G.W.Niklas 34-2-1

det. Der Zeiger war schwarz lackiert und die Führungsnut befand sich auf der Rückseite des Zeigers, so daß sie bei Betrachtung des Instrumentes nicht sichtbar war. Die Broncekugel konnte im Zeiger zur Balancierung mittels eines abgebogenen Stiftes, der durch eine seitliche Öffnung des Meßgerätegehäuses eingeführt wurde, leicht in die richtige Lage geschoben werden. Infolge des langen Balancierweges ist eine sehr genaue Ausbalancierung möglich. Besondere Balancierarme entfallen und der Massekörper ist bei der beschriebenen Ausführungsform auch nicht sichtbar.

H.G.Mirbeth-E.H.Nentwich-G.W.Niklas 34-2-1


Patentansprüche


1. Meßinstrument mit einem um eine Meßwerkachse drehbaren Meßwerkteil und einem radial auf der Achse befestigten Zeiger, bei dem zum Ausbalancieren der beweglichen Massen mit der Meßwerkachse verbundene, radial hierzu verschiebbare Massekörper vorgesehen sind, d a d u r c h  g e k e n n - z e i c h n e t, daß die Massekörper (2, 3, 4, 6, 9) längs des Zeigers (1) verschiebbar angeordnet sind.

2. Meßinstrument nach Anspruch 1, dadurch gekennzeichnet, daß Massekörper (2, 3, 4) auf dem Zeiger (1) verschiebbar angeordnet sind.

3. Meßinstrument nach Anspruch 2, dadurch gekennzeichnet, daß auf dem Zeiger (1) als Massekörper ein Stück Schrumpfschlauch (2) angeordnet ist.

4. Meßinstrument nach Anspruch 2, dadurch gekennzeichnet, daß auf dem Zeiger (1) ein O-Ring (3) angeordnet ist.

5. Meßinstrument nach Anspruch 2, dadurch gekennzeichnet, daß auf dem Zeiger (1) eine Drahtklammer (4) angeordnet ist.

ZT/P21-Fr/gu
20.09.1983                                          - 2 -

0135918

H.G.Mirbeth-E.H.Nentwich-G.W.Niklas 34-2-1

6. Meßinstrument nach Anspruch 1, dadurch gekennzeichnet, daß der Zeiger (1) hohl ausgebildet ist und im Hohlraum (5) ein Massekörper (6, 9) verschiebbar angeordnet ist.

7. Meßinstrument nach Anspruch 1, dadurch gekennzeichnet, daß der Zeiger (1) in Längsrichtung eine Führungsnut (8) hat, in der ein Massekörper (9) verschiebbar angeordnet ist.

8. Meßinstrument nach Anspruch 7, dadurch gekennzeichnet, daß die Führungsnut (8) auf der Zeigerrückseite angeordnet ist.

9. Meßinstrument nach Anspruch 7 und 8, dadurch gekennzeichnet, daß die Führungsnut (8) durch Umfalten der Längsränder (10) des Zeigers (1) gebildet ist.

10. Meßinstrument nach einem der Ansprüche 7 bis 9, dadurch gekennzeichnet, daß die Führungsnut (8) den Massekörper (9) auf mehr als 180$^{\circ}$ seines Umfangs umfaßt.

11. Meßinstrument nach Anspruch 10, dadurch gekennzeichnet, daß die Führungsnut (8) mindestens an einem Ende einen verbreiterten Ausschnitt (11) zum Einführen des Massekörpers (9) hat.

12. Meßinstrument nach einem der Ansprüche 6 bis 11, dadurch gekennzeichnet, daß der Massekörper (9) eine Metallkugel ist.

13. Meßinstrument nach einem der Ansprüche 6 bis 11, dadurch gekennzeichnet, daß der Massekörper (9) ein Metallzylinder ist.

0135918

H.G.Mirbeth-E.H.Nentwich-G.W.Niklas 34-2-1

14. Meßinstrument nach Anspruch 12 und 13, dadurch gekennzeichnet, daß der Massekörper (9) aus einem nicht magnetisierbaren Material besteht.

15. Meßinstrument nach Anspruch 12 und 13, dadurch gekennzeichnet, daß der Massekörper (9) mindestens teilweise aus magnetisierbarem Material besteht.

16. Meßinstrument nach einem der Ansprüche 7 bis 15, dadurch gekennzeichnet, daß die Führungsnut (8) so ausgebildet ist, daß der Massekörper (9) zwischen Längskanten gehalten ist.

17. Meßinstrument nach Anspruch 16, dadurch gekennzeichnet, daß der Zeiger (1) im Bereich der Führungsnut (8) einen an einer Seite unterbrochenen sternförmigen Querschnitt hat.

0135918

FIG.1    FIG.2    FIG.3

FIG.4

FIG.5

H.G.Mirbeth-E.H.Nentwich-G.W.Niklas 34-2-1

## FIG.6

A

A

1

## FIG.7

11    8    10    1

9    10

## FIG.8

9    1

10    10

7

0135918

**Europäisches Patentamt**

# EUROPÄISCHER RECHERCHENBERICHT

Nummer der Anmeldung

| | EINSCHLÄGIGE DOKUMENTE | | EP 84111218.8 |
|---|---|---|---|

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE - C - 118 721 (HARTMANN & BRAUN) | 1,2 | G 01 D 11/08 |
| A | * Fig. 1 * | 3-5 | G 01 D 13/22 |
| | -- | | G 01 R 1/08 |
| X | US - A - 2 575 720 (LENEHAN) | 1,6-10, 16 | G 12 B 11/04 |
| A | * Fig. 1-6 * | 2-5, 11-15, 17 | |
| | -- | | |
| X | GB - A - 177 911 (THOMSON - HOUSTON) | 1,2,5 | |
| | * Fig. 1, Nr. 19 * | | |
| | -- | | |
| X | GB - A - 655 772 (ELLIOT BROTHERS) | 1,2,4 | |
| | * Fig. 1,2 * | | RECHERCHIERTE SACHGEBIETE (Int. Cl.4) |
| | -- | | |
| X | GB - A - 6 991/A.D. 1898 (WESTON) | 1,2 | G 01 D 11/00 |
| A | * Fig. 1,2 * | 13 | G 01 D 13/00 |
| | ---- | | G 01 R 1/00 |
| | | | G 12 B 11/00 |

Der vorliegende Recherchenbericht wurde für alle Patentansprüche erstellt.

| Recherchenort | Abschlußdatum der Recherche | Prüfer |
|---|---|---|
| WIEN | 16-11-1984 | KUNZE |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82